# EUROPEAN PATENT SPECIFICATION

(11) **EP 0 290 578 B1**
(45) Date of publication and mention of the grant of the patent: **07.07.1993**
(21) Application number: 87908092.7
(22) Date of filing: 25.11.1987
(51) Int. Cl.: C04B 41/88, H01L 21/48

(54) **TUNGSTEN PASTE FOR CO-SINTERING WITH PURE ALUMINA AND METHOD FOR PRODUCING SAME**
WOLFRAM-PASTE ZUM CO-SINTERN MIT REINER TONERDE UND VERFAHREN ZU SEINER HERSTELLUNG
PATE DE TUNGSTENE POUR LE FRITTAGE COMBINE AVEC DE L'ALUMINE PURE ET PROCEDE DE PRODUCTION

(30) Priority: 26.11.1986 US 935264
(43) Date of publication of application: 17.11.1988
(73) Proprietor: CERAMICS PROCESS SYSTEMS CORPORATION, Milford, Massachusetts 01757 (US)
(72) Inventor: BARRINGER, Eric, A., Walthan, MA 02154 (US); LIND, Rogers, Acton, MA 01718 (US); HODGE, James, D., Medway, MA 02053 (US); FOSTER, Bryant, C., Sutton, MA 01527 (US)
(74) Representative: Overbury, Richard Douglas
(86) International application number: PCT/US87/03124
(87) International publication number: WO 88/03919

(56) References cited:
- EP-A- 0 230 675
- GB-A- 980 975
- GB-A- 1 017 487
- US-A- 3 993 821
- US-A- 4 404 154
- Chemical Abstracts, vol. 104, no. 20, May 1986, (Columbus, Ohio, US), p. 293, abstract no. 173209u
- Chemical Abstracts, vol. 94, 1981, (Columbus, Ohio, US), p. 282, abstract no. 196539r

## Description

This invention relates to a substrate having a conductive layer and is concerned with such substrates for use as ceramic packages for integrated circuits.

Ceramics have found widespread use in electronics as a substrate for integrated circuit packages. Metallized circuit patterns are applied to the ceramic substrate, and ceramic and metallization are co-sintered to create a monolith of substrate and circuitry. Multi-layer circuit packages are constructed by combining ceramic particles and organic binder into unfired, or "green," tape. Inter-layer conductive paths, known as "vias," are then inserted through layers, forming electrical interconnections between the circuits on each layer after they are stacked and processed. Thereafter, metallized circuit patterns are applied. The tape layers typically have thicknesses ranging from 5 to 25 mil (1.27 x 10⁻⁴ to 6.35 x 10⁻⁴m). Holes and notches are formed in the layers as required. Multiple layers of printed tape are stacked and then laminated under pressure, and ceramic and metallization co-sintered to form a monolithic structure with three-dimensional circuitry.

Typically, substrates are formed from a combination of approximately 90-94% commercial alumina, and 6-10% silicon-based glass (by weight), and tungsten or molybdenum/manganese paste is used to form the metallized conductive paths. The glass is added to the alumina to promote bonding of the tungsten to the alumina and to provide sintering of the alumina at a lower temperature than for 98+% (by weight) commercial alumina. (Hereafter substrate compositions are referred to as percentage by weight values unless otherwise stated.) In prior art 100% tungsten paste formulations, the glass component is used in the alumina substrate to facilitate adhesion of the tungsten and alumina particles. Upon firing, the glass component migrates into the tungsten layer, providing interface adhesion between the paste component and substrate. Circuit packages produced from this prior art formulation display a dielectric constant of approximately 9-9.5, thermal conductivity of approximately 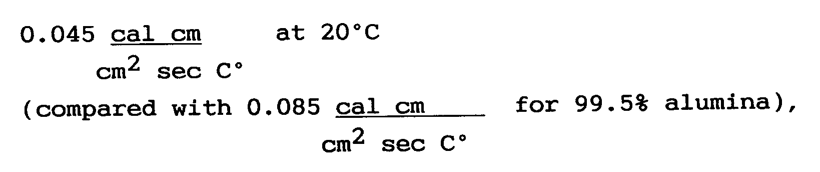
shrinkage variability of 0.5% - 1.0%, and a surface finish of greater than 25 microinches (63.5 x 10⁻⁴m). While these substrate properties may have been acceptable for conventional semiconductor packages, they are inadequate for high-performance large scale integration circuitry.

US Patent 3993821 discloses that beryllia substrates may be co-fired with metallizing compositions containing low weight percentages of high purity beryllia in the absence of glassy additives to promote binding. Whereas it had been reported in the prior art that co-firing of beryllia with conventional metallizations resulted in poor adhesion of the metal to the substrate as a consequence of leakage of glassy binder into the ceramic structure before completion of the process, favourable adhesive properties were demonstrated for the invention of US patent 3993821.

European patent 0230675 (prior art under Article 54 paragraph 3) describes a process enabling a conductive strip to be incorporated onto a mullite ceramic substrate in which two sintering additives are used to circumvent the problem of poor adhesion between ceramic and conductor. One sintering additive is used for the mullite ceramic substrate and a second different sintering additive is also used for the conductive strip. Whilst the sintering additives disclosed imparted favourable binding characteristics they require a temperature of 1550°C or greater in the firing process to ensure adequate binding.

Surface finish becomes increasingly important as the size of circuit features such as pads and vias decreases. In microelectronic circuits produced by thin-film metallization techniques, the conductor thickness can be as small as a few micrometers, so that if the substrate has a 25 microinches (63.5 x 10⁻⁴m) surface finish typical of the prior art, the conductor path will have substantial differences in thickness along its length, or may even be discontinuous, with a corresponding deterioration in function. Accordingly, roughness of surface finish prevents post-firing circuit personalization by thin-film metallization.

Moreover, porosity of the as-fired surface, especially when combined with roughness of the surface, leads to the problem of retention of plating salts. Aggressive cleaning procedures are required to avoid deposition of plating where not desired, and to avoid blistering upon firing. Greater smoothness and lack of porosity would allow the use of more active catalysts, which, in turn would increase product yield through electroless plating operations.

Reduction in shrinkage variability is also especially important as feature size decreases, and a reduction in shrinkage variability from the prior art 0.5-1.0% level would increase yield. This is because variability in shrinkage prevents precise location of integrated circuit pads, vias, and other devices and interconnects and increases the probability of discontinuities necessitating discarding of the product. The need for reduction in shrinkage variability extends to both the manufacturer of substrates and the substrate consumer, who requires substrates and the substrate consumer, who requires precise positioning of devices and interconnects and, in a few special cases, reliable circuit personalization by thin-film metallization.

Accordingly, there exists a need for a substrate/metallization system with greater thermal conductivity, lower shrinkage variability, and better surface finish, while maintaining the desired dielectric and electrical properties.

It has been found that a tungsten and/or molybdenum paste suitable for co-sintering with, for example 98+% alumina, at relatively low temperatures, can be produced by adding a glass to the paste.

According to a first aspect of the present invention there is provided a process for producing a substrate having a conductive layer, comprising:
(a) obtaining a green tape consisting of substrate particles;
(b) mixing into a paste at least one metal selected from the group consisting of tungsten and molybdenum and a glass which wets both the metal and the substrate particles;
(c) applying the resulting metal-glass paste to a surface of the green tape; and
(d) co-firing the tape with the applied paste characterised in that the substrate particles have a mean particle size of from 0.3 to 1.0 micrometer and are selected from; at least 98% alumina, beryllia, zirconia, aluminium nitride and silicon nitride and in that the co-firing is effected at a sintering temperature between 1450 and 1550°C.

According to a second aspect of the present invention there is provided a fired substrate having a conductive layer, the substrate being derived from a green tape consisting of substrate particles which have a mean particle size of from 0.3 to 1.0 micrometer and are selected from; at least 98% alumina, beryllia, zirconia, aluminium nitride and silicon nitride, the conductive layer being derived from a paste applied to the green tape, which paste comprises at least one metal selected from tungsten and molybdenum, and a glass which wets both the metal and the substrate particles, the substrate having a sintering temperature between 1450°C and 1550°C.

Circuit packages formed from the substrates produced in accordance with the present invention exhibit superior thermal conductivity, low shrinkage variability, and smoother and more homogeneous surface finish. By employing narrow size range substrate particles, shrinkage and surface finish parameters are still further improved, and sintering temperature is reduced. Further details and embodiments of the invention are described below.

The use of narrow size range particles allows sintering at low temperatures, typically 1500 to less than 1550°C compared with 1600-1700°C for wide size range particles typical of commercially available powders. Moreover, this lower sintering temperature for narrow size range substrate particles is achieved without the necessity of adding glass to the particles, with its concomitant decrease in thermal conductivity. It is preferred for the particles to have the aforementioned mean particle size with a standard deviation approximately 50% of mean.

Using narrow size range substrate particles also permits more uniform green densities, and when a 98+% alumina is used, produces a fired ceramic having an excellent surface finish suitable for thin film deposition. In contrast, typical prior art substrates produced from wide size range 90-94% alumina and 6-10% glass require polishing for thin film applications, which increases cost and creates voids.

The use of 98+% alumina and preferably 99+% alumina, is advantageous since 98+% alumina exhibits substantially higher thermal conductivity than 90% alumina does, regardless of particle size. The respective thermal conductivities of 92% and 99.5% alumina at 20°C are 0.045 and 0.085 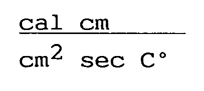
(0.188 and 0.356 W cm⁻¹ K⁻¹).

The use of 98+% Al₂O₃ substrate precludes the use of the tungsten metallization common with the prior art, which typically consists of organic solvent, polymeric binder, and tungsten powder. Instead, a preferred embodiment of the invention for surface metallization generally involves the steps of mixing tungsten particles having an average particle size of approximately 0.5-2.0 micrometers with an ethyl cellulose solution, and adding to the mixture, alkaline earth aluminosilicate powder having selected ratios of one or more of the following: CaO, BaO, MgO, Al₂O₃, and SiO₂. Preferably the weight ratios of the components of the glass are as follows: alkaline earth 10-38%, alumina 10-52%, and silica 10-70%, although other ratios are possible. Upon firing, the glass flows into the alumina body thereby creating a bond phase. In particular, it is desirable that the glass remain in the region of the interface between the tungsten and the alumina; if the glass migrates more generally into the substrate, bonding of the tungsten may be adversely affected. The composition and ratios of the glass component are tailored to adjust the melting point and viscosity characteristics of the glass to maximize metallization adherence to ceramic. For example, the paste may comprise from 7 to 40 volume % of alkaline earth aluminosilicate. It is possible, however, to utilize proportions of glass outside of this range. The resulting mixture is milled and applied in a thin layer to a green tape of 98+% narrow size range alumina particles. Typically, approximately 5 to 35 volume percent glass is present in the fired metallization.

In formulations for via fill in accordance with the present invention, one may typically employ tungsten particles ranging in size from 0.5 to 4.0 micrometers with an ethyl cellulose or polyvinylbutyral solution, and add to the mixture an alkaline earth aluminosilicate powder (as defined above). In addition, alumina and zirconia can be added to adjust the shrinkage and thermal expansion properties of the metallization. Typically, for via fill applications, the fired metallization may include 40 to 70 volume percent tungsten, 25 to 10 volume percent aluminosilicate glass, and 50 to 20 volume percent alumina and/or zirconia.

In the case of either via fills or surface metallization, the tape/paste composite is then fired at between 1450 and 1550°C in an atmosphere of dissociated ammonia and nitrogen (50% H₂ and 50% N₂) and water vapour at a dew point ranging from 15-45°C. Alternatively, multiple layers of paste and alumina substrate can be laminated and co-sintered to form a ceramic monolith with a three dimensional conductor system.

Tungsten sintering aids known in the art, such as nickel, cobalt, palladium, or 0.02-0.10 weight percent nickel are employed. These metal dopants form an active liquid phase to facilitate sintering. Additionally, sintering may be enhanced by using finer particle sizes and by pre-reducing the tungsten powder (removing the oxide component) prior to producing the paste mixture. Improved sintering provides greater hermeticity, that is, the sealing of gases from the alumina body and greater metallization bond strength.

It will be appreciated that the present invention may be employed with molybdenum in lieu of tungsten, co-sintered at a lower temperature than typically used with prior art formulations. The paste formulations in accordance with the present invention may also be suitable for co-firing and/or for post-firing applications. It will be appreciated furthermore that the invention may be utilized in connection with beryllia, zirconia, aluminium nitride and silicon nitride substrates, which have sintering temperatures between 1450 and 1550°C for co-firing and as high as 1600°C for post-firing. It will additionally be appreciated that glasses other than alkaline earth aluminosilicates may be satisfactorily employed in paste formulations in accordance with the present invention, the principal criteria being that in firing, the glass wets both the metal and the ceramic substrate and does not adversely react with these materials. Other suitable glasses include aluminates.

The following examples are illustrative of the invention:

### Example 1

67 parts by weight of tungsten powder having an average particle size of 1-2 micrometers and 33 parts by weight of an 8% ethyl cellulose solution were mixed. To this mixture a MgO/Al₂O₃/SiO₂ powder of the composition 14.0% MgO,33.7% Al₂O₃,52.3% SiO₂ was added in the amount of 37% by volume, based on the amount of tungsten in the mixture. This mixture was blended in a ceramic mill jar filled with tungsten carbide shot for 2 hours. The mixture was then subjected to 3 passes through a 3 roll ink mill using 1.5 mil (3.81 x 10⁻⁵m) roller spacing. Samples were screen printed on 99+% alumina green tape and fired at a peak temperature between 1475 and 1550°C for 2 hours on a 50:50 H₂/N₂ atmosphere with a 34°C dewpoint. Measured bulk resistivities for 10 and 20 mil (2.54 x 10-4 and 5.08 x 10⁻⁴m) line width surface traces were 0.010 milliohms/in (3.94 x 10⁻⁴ Ω m⁻¹).

### Example 2

67 parts by weight of tungsten powder having an average particle size of 1-2 micrometers and 33 parts by weight of an 8% ethyl cellulose solution were mixed. To this mixture a MgO/Al₂O₃/SiO₂ powder of the composition 16.3% MgO,29.1% Al₂O₃,54.6% SiO₂ was added in the amount of 37% by volume, based on the amount of tungsten in the mixture. This mixture was blended in a ceramic mill jar filled with tungsten carbide shot for 2 hours. The mixture was then subjected to 3 passes through a 3 roll ink mill using 1.5 mil (3.81 x 10⁻⁵m) roller spacing. Samples were screen printed on 99+% alumina green tape and fired at a peak temperature between 1475 and 1550°C for 2 hours in a 50:50 H₂/N₂ atmosphere with a 34°C dewpoint. Measured bulk resistivities for 10 and 20 mil (2.54 x 10⁻⁴ and 5.08 x10⁻⁴m) line width surface traces were 0.010 milliohms/in (3.94 x 10⁻⁴ Ω m⁻¹).

### Example 3

67 parts by weight of tungsten powder having an average particle size of 1-2 micrometers and 33 parts by weight of an 8% ethyl cellulose solution were mixed. To this mixture a MgO/Al₂O₃/SiO₂ powder of the composition 16.3% MgO,29.1% Al₂O₃,54.6% SiO₂ was added in the amount of 15% by volume, based on the amount of tungsten in the mixture. Following this addition 0.02% by weight of Ni dissolved in 25 ml. of HNO₃ was added to the mixture. This mixture was blended in a ceramic mill jar filled with tungsten carbide shot for 2 hours. The mixture was then subjected to 3 passes through a 3 roll ink mill using 1.5 mil (3.81 x 10⁻⁵m) roller spacing. Samples were screen printed on 99+1% alumina green tape and fired at a peak temperature between 1475 and 1550°C for 2 hours in a 50:50 H₂/N₂ atmosphere with a 34°C dewpoint. Measured bulk resistivities for 10 and 20 mil (2.54 x 10⁻⁴ and 5.08 x 10⁻⁴m) line width surface traces were 0.010 milliohms/in (3.94 x 10⁻⁴ Ω m⁻¹).

### Example 4

65 parts by weight of a W powder having an average particle size of 1-2 micrometers and 35 parts by weight of an 8% ethyl cellulose solution were mixed. To this mixture a CaO/Al₂O₃/SiO₂ powder of the composition 29.3% CaO,39.0% Al₂O₃,31.7% SiO₂ was added in the amount of 35% by volume, based on the amount of W in the mixture. This mixture was blended in a ceramic mill jar filled with tungsten carbide shot for 2 hours. The mixture was then subjected to 3 passes through a 3 roll ink mill using 1.5 mil (3.81 x 10⁻⁵m) roller spacing. Samples were screen printed on 99+% alumina green tape and fired at a peak temperature between 1475 and 1550°C for 2 hours in a 50:50 H₂/N₂ atmosphere with a 34°C dewpoint.

### Example 5

65 parts by weight of a W powder having an average particle size of 1-2 micrometers and 35 parts by weight of an 8% ethyl cellulose solution were mixed. To this mixture a CaO/Al₂O₃/SiO₂ powder of the composition 37.7% CaO,52.3% Al₂O₃,10.0% SiO₂ was added in the amount of 35% by volume, based on the amount of W in the mixture. This mixture was blended in a ceramic mill jar filled with tungsten carbide shot for 2 hours. The mixture was then subjected to 3 passes through a 3 roll ink mill using 1.5 mil (3.81 x 10⁻⁵m) roller spacing. Samples were screen printed on 99+% alumina green tape and fired at a peak temperature between 1475 and 1550°C for 2 hours in a 50:50 H₂/N₂ atmosphere with a 34°C dewpoint.

### Example 6

65 parts by weight of a W powder having an average particle size of 1-2 micrometers and 35 parts by weight of an ethyl cellulose solution were mixed. To this mixture a CaO/MgO/Al₂O₃/SiO₂ powder of the composition 15.2% CaO,8.6% MgO, 16.6% Al₂O₃,59.6% SiO₂ was added in the amount of 35% by volume, based on the amount of W in the mixture. This mixture was blended in a ceramic mill jar filled with tungsten carbide shot for 2 hours. The mixture was then subjected to 3 passes through a 3 roll ink mill using 1.5 mil (3.81 x 10⁻³m) roller spacing. Samples were screen printed on 99+% alumina green tape and fired at a peak temperature between 1475 and 1550°C for 2 hours in a 50:50 H₂/N₂ atmosphere with a 34°C dewpoint.

### Example 7

64 parts by weight of a metal/ceramic composite was mixed with 36 parts by weight of an organic vehicle. The composite consisted of 36.8 volume percent W, 29.4 volume percent Al₂O₃, 26.4 volume percent SiO₂, and 7.4 volume percent CaO/Al₂O₃/SiO₂ of the composition 23.1 weight percent CaO, 41.2 weight percent Al₂O₃, 35.7 weight percent SiO₂. The organic vehicle comprised 10 parts by weight ethyl cellulose, 4 parts by weight of a wetting agent and 86 parts by weight of solvent. This mixture was blended in a ceramic mill jar filled with tungsten carbide shot for 2 hours. The mixture was then subjected to 3 passes through a 3 roll ink mill using 1.5 mil (3.81 x 10⁻⁵m) roller spacing. Samples were screen printed on 99+% alumina green tape and fired at a peak temperature between 1475 and 1550°C for 2 hours in a 50:50 H₂/N₂ atmosphere with a 34°C dewpoint.

## Claims

1. A process for producing a substrate having a conductive layer, comprising:
(a) obtaining a green tape consisting of substrate particles;
(b) mixing into a paste at least one metal selected from the group consisting of tungsten and molybdenum and a glass which wets both the metal and the substrate particles;
(c) applying the resulting metal-glass paste to a surface of the green tape; and
(d) co-firing the tape with the applied paste characterised in that the substrate particles have a mean particle size of from 0.3 to 1.0 micrometer and are selected from; at least 98% alumina, beryllia, zirconia, aluminium nitride and silicon nitride and in that the co-firing is effected at a sintering temperature between 1450 and 1550°C.

2. A process according to claim 1, wherein the glass is selected from the group consisting of alkaline earth aluminosilicates and aluminates.

3. A process according to claim 1 or 2 wherein the alkaline earth aluminosilicate is CaO/Al₂O₃/SiO₂, MgO/Al₂O₃/SiO₂ or CaO/MgO/Al₂O₃/Si0₂.

4. A process according to claim 1, 2 or 3 wherein the fired paste comprises from 5 to 35 vol % of the glass, based on said metal.

5. A process according to claim 1, 2 or 3, wherein the substrate consists of particles containing at least 98% alumina and wherein the paste applied to the green tape includes tungsten and no more than 37%, based on the tungsten, of CaO/Al₂O₃/Si0₂ or MgO/Al₂O₃/Si0₂.

6. A process according to claim 1, 2 or 3 wherein the paste includes tungsten, the glass is an alkaline earth aluminosilicate, and the substrate consists of at least 98% alumina particles, wherein the paste applied to the green tape comprises from 7 to 40 vol % of the alkaline earth aluminosilicate.

7. A process according to any one of the preceding claims, wherein the substrate particles are at least 99% alumina.

8. A process according to any preceding claim wherein the co-firing is effected at a temperature between 1475 and 1550°C.

9. A fired substrate having a conductive layer, the substrate being derived from a green tape consisting of substrate particles which have a mean particle size of from 0.3 to 1.0 micrometer and are selected from; at least 98% alumina, beryllia, zirconia, aluminium nitride and silicon nitride, the conductive layer being derived from a paste applied to the green tape, which paste comprises at least one metal selected from tungsten and molybdenum, and a glass which wets both the metal and the substrate particles, the substrate having a sintering temperature between 1450°C and 1550°C.

10. A substrate according to claim 9, wherein the glass is selected from the group comprising alkaline earth aluminosilicates and aluminates.

11. A substrate according to claim 9 or 10, wherein the alkaline earth aluminosilicate is CaO/Al₂O₃/SiO₂, MgO/Al₂O₃/SiO₂ or CaO/MgO/Al₂O₃/Si0₂.

12. A substrate according to claims 9, 10 or 11, wherein the paste comprises 5 to 35 vol % of the glass.

13. A substrate according to any of claims 9, 10 or 11, wherein the paste includes tungsten and no more than 37% CaO/Al₂O₃/SiO₂ or MgO/Al₂O₃/SiO₂ and the substrate consists of particles containing at least 98% alumina.

## Patentansprüche

1. Verfahren zur Herstellung eines Substrats mit einer leitenden Schicht, enthaltend:
(a) Bereitstellen eines "grünen" (ungebrannten) Bandes aus Substratpartikeln;
(b) Mischen wenigstens eines Metalls, das aus der aus Wolfram und Molybdän bestehenden Gruppe ausgewählt wird, und ein Glas, welches sowohl das Metall als auch die Substratpartikel benetzt in eine Paste;
(c) Aufbringen der sich ergebenden Metall-Glas-Paste auf eine Oberfläche des grünen Bandes; und
(d) gemeinsames Brennen des Bandes mit der aufgebrachten Paste,
dadurch gekennzeichnet, daß die Substratpartikel eine mittlere Partikelgröße von 0,3 bis 1,0 µm aufweisen und ausgewählt werden aus: wenigstens 98% Tonerde, Berylliumoxid, Zirkonerde, Aluminiumnitrid und Siliziumnitrid, und dadurch, daß das gemeinsame Brennen bei einer Sintertemperatur zwischen 1450 und 1550°C durchgeführt wird.

2. Verfahren nach Anspruch 1, bei welchem das Glas aus der aus Erdalkali-Aluminosilikaten und -Aluminaten bestehenden Gruppe ausgewählt wird.

3. Verfahren nach Anspruch 1 oder 2, bei welchem das Erdalkali-Aluminosilikat CaO/Al₂O₃/SiO₂, MgO/Al₂O₃/SiO₂ oder CaO/MgO/ Al₂O₃/SiO₂ ist.

4. Verfahren nach Anspruch 1, 2 oder 3, bei welchem die gebrannte Paste 5 bis 35 Vol.-% Glas, bezogen auf das Metall, aufweist.

5. Verfahren nach Anspruch 1, 2 oder 3, bei welchem das Substrat aus Partikeln besteht, die wenigstens 98% Tonerde enthalten, und wobei die auf das grüne Band aufgebrachte Paste Wolfram und nicht mehr als 37%, bezogen auf das Wolfram, von CaO/ Al₂O₃/SiO₂ oder MgO/Al₂O₃/SiO₂ enthält.

6. Verfahren nach Anspruch 1, 2 oder 3, bei welchem die Paste Wolfram enthält, das Glas ein Erdalkali-Aluminosilikat ist, und das Substrat aus wenigstens 98% Tonerdepartikeln besteht, wobei die auf das grüne Band aufgebrachte Paste 7 bis 40 Vol.-% des Erdalkali-Aluminosilikats aufweist.

7. Verfahren nach einem der vorhergehenden Ansprüche, bei welchem die Substratpartikel wenigstens 99% Tonerde sind.

8. Verfahren nach einem der vorhergehenden Ansprüche, bei welchem das gemeinsame Brennen bei einer Temperatur zwischen 1475 und 1550°C durchgeführt wird.

9. Gebranntes Substrat mit einer leitenden Schicht, welches aus einem "grünen" (ungebrannten) Band abgeleitet ist, das aus Substratpartikeln besteht, welche eine mittlere Partikelgröße von 0,3 bis 1,0 µm aufweisen und ausgewählt sind aus: wenigstens 98% Tonerde, Berylliumoxid, Zirkonerde, Aluminiumnitrid und Siliziumnitrid, wobei die leitende Schicht von einer Paste abgeleitet ist, welche auf das grüne Band aufgebracht worden ist, welche wenigstens ein aus Wolfram und Molybdän ausgewähltes Metall aufweist, sowie ein Glas, das sowohl das Metall als auch die Substratpartikel benetzt, wobei das Substrat eine Sintertemperatur zwischen 1450°C und 1550°C hat.

10. Substrat nach Anspruch 9, bei welchem das Glas aus der Gruppe ausgewählt wird, die Erdalkali-Aluminosilikate und -Aluminate aufweist.

11. Substrat nach Anspruch 9 oder 10, bei welchem das Erdalkali-Aluminosilikat CaO/Al₂O₃/SiO₂, MgO/Al₂O₃/SiO₂ oder CaO/MgO/ Al₂O₃/SiO₂ ist.

12. Substrat nach Anspruch 9, 10 oder 11, bei welchem die Paste 5 bis 35 Vol.-% an Glas aufweist.

13. Substrat nach einem der Ansprüche 9, 10 oder 11, bei welchem die Paste Wolfram und nicht mehr als 37% CaO/Al₂O₃/SiO₂ oder MgO/Al₂O₃/SiO₂ aufweist, und das Substrat aus Partikeln besteht, die wenigstens 98% Tonerde enthalten.

## Revendications

1. Procédé de fabrication d'un substrat comportant une couche conductrice, consistant à :
(a) obtenir une bande-ruban crue (non cuite) constituée de particules de substrat ;
(b) mélanger en une pâte au moins un métal choisi dans le groupe constitué par le tungstène et le molybdène et un verre qui mouille à la fois le métal et les particules de substrat ;
(c) appliquer la pâte métal-verre qui en résulte sur une zone de la bande-ruban crue ; et
(d) co-fritter la bande-ruban et la pâte qui y a été appliquée,
caractérisé en ce que les particules de substrat ont une taille moyenne de 0,3 à 1,0 micron et sont choisies parmi : au moins 98% d'alumine, l'oxyde de beryllium, l'oxyde de zirconium, le nitrure d'aluminium et le nitrure de silicium et en ce que le co-frittage est effectué à une température de frittage comprise entre 1450 et 1550°C ;

2. Procédé selon la revendication 1, dans lequel le verre est choisi dans le groupe constitué par des alumino-silicates alcalino-terreux et des aluminates.

3. Procédé selon l'une des revendications 1 ou 2, dans lequel l'alumino-silicate alcalino-terreux est du CaO/Al₂O₃/SiO₂, MgO/Al₂O₃/SiO₂ ou Cao/Mgo/Al₂O₃/SiO₂.

4. Procédé selon l'une des revendications 1, 2 ou 3 dans lequel la pâte frittée contient de 5 à 35 % en volume de verre, par rapport au métal.

5. Procédé selon l'une des revendications 1, 2 ou 3, dans lequel le substrat comprend des particules contenant au moins 98% d'alumine et dans lequel la pâte appliquée à la bande-ruban crue comprend du tungstène et pas plus de 37%, par rapport au tungstène, de CaO/Al₂O₃/SiO₂ ou MgO/Al₂O₃/SiO₂.

6. Procédé selon l'une des revendications 1, 2 ou 3 dans lequel la pâte comprend du tungstène, le verre est un alumino-silicate alcatino-terreux, et le substrat est constitué d'au moins 98% de particules d'alumine, dans lequel la pâte appliquée à la bande-ruban crue comprend de 7 à 40 % en volume d'alumino-silicate alcalino-terreux.

7. Procédé selon l'une quelconque des revendications précédentes, dans lequel les particules de substrat contiennent au moins 99% d'alumine.

8. Procédé selon l'une quelconque des revendications précédentes, dans lequel le co-frittage est effectué à une température comprise entre 1475 et 1550°C.

9. Substrat fritté ayant une couche conductrice, le substrat étant dérivé d'une bande-ruban crue constituée de particules de substrat qui ont une taille moyenne de 0,3 à 1.0 micron et qui sont choisies parmi : au moins 98% d'alumine, l'oxyde de beryllium, l'oxyde de zirconium, le nitrure d'aluminium et le nitrure de silicium, la couche conductrice dérivant d'une pâte appliquée à la bande-ruban crue, ladite pâte comprenant au moins un métal choisi parmi le tungstène et le molybdène, et un verre qui mouille à la fois le métal et tes particules de substrat, le substrat ayant une température de frittage comprise entre 1450°C et 1550°C.

10. Substrat selon la revendication 9, dans lequel le verre est choisi dans te groupe constitué par des alumino-silicates alcalino-terreux et des aluminates.

11. Substrat selon l'une des revendications 9 ou 10, dans lequel l'alumino-silicate alcalino-terreux est du CaO/Al₂O₃/SiO₂, MgO/Al₂O₃/SiO₂ ou CaO/MgO/Al₂O₃/SiO₂.

12. Substrat selon l'une des revendications 9, 10 ou 11, dans lequel la pâte comprend de 5 à 35 % en volume de verre.

13. Substrat selon l'une quelconque des revendications 9, 10 ou 11, dans lequel la pâte comprend du tungstène et pas plus de 37% de CaO/Al₂O₃/SiO₂ ou de MgO/Al₂O₃/SiO₂ et le substrat est constitué de particules contenant au moins 98% d'alumine.
